# EUROPÄISCHE PATENTSCHRIFT

(11) **EP 3 224 859 B1**
(45) Veröffentlichungstag und Bekanntmachung des Hinweises auf die Patenterteilung: **30.10.2024**
(21) Anmeldenummer: 15830976.5
(22) Anmeldetag: 24.11.2015
(51) Int. Cl.: H01L 21/67, H01L 21/677, H01L 21/306

(54) **VERFAHREN UND VORRICHTUNG ZUR UNTERSEITIGEN BEHANDLUNG EINES SUBSTRATS**
METHOD AND DEVICE FOR TREATING THE UNDERSIDE OF A SUBSTRATE
PROCÉDÉ ET DISPOSITIF POUR LE TRAITEMENT DE LA FACE INFÉRIEURE D'UN SUBSTRAT

(30) Priorität: 25.11.2014 DE 102014117276
(43) Veröffentlichungstag der Anmeldung: 04.10.2017
(73) Patentinhaber: RENA Technologies GmbH, 78148 Gütenbach (DE)
(72) Erfinder: WEISE, Katrin, 81927 München (DE); SANDER, Bernd-Uwe, 79111 Freiburg (DE); QUEISSER, Steffen, 77731 Willstätt (DE); GANTER, Patrick, 78120 Furtwangen (DE); PEDIADITAKIS, Stephan Alexis, 79194 Heuweiler (DE)
(74) Vertreter: Heyerhoff Geiger GmbH & Co. KG
(86) Internationale Anmeldenummer: PCT/DE2015/100502
(87) Internationale Veröffentlichungsnummer: WO 2016/082826

(56) Entgegenhaltungen:
- WO-A1-2010/025125
- WO-A1-2010/041328
- WO-A1-2011/035748
- WO-A1-2012/020274
- CN-A- 103 811 583
- DE-A1- 102006 049 488
- DE-A1- 102009 050 845
- US-A1- 2010 055 398

## Beschreibung

Die Erfindung betrifft ein Verfahren zum unterseitigen Behandeln eines flächigen Substrats sowie eine Vorrichtung zur Durchführung des Verfahrens gemäß dem Anspruch Unter anderem ist es im Bereich der Fertigung von Halbleiterbauelementen zum Teil erforderlich, flächige Substrate einseitig zu behandeln. Häufig wird zu diesem Zwecke eine Unterseite des Substrats behandelt. Je nach Anwendungsfall kann es dabei erforderlich sein, die Oberseite des Substrats vor einer Einwirkung des eingesetzten Behandlungsmediums oder etwaigen schädlichen Ausgasungen aus dem Behandlungsmedium zu schützen. Beispielsweise können Halbleiterbauelemente durch eine derartige Einwirkung auf die Oberseite geschädigt werden.

Aus WO 2011/047894 A1 ist bekannt, zum Schutz der Oberseite des Substrats auf die Oberseite eine Schutzflüssigkeit aufzusprühen, aufzuspritzen, aufzutropfen oder mittels Schwallrohren aufzubringen. Damit die Schutzflüssigkeit nicht in das Behandlungsmedium, üblicherweise eine Behandlungsflüssigkeit, gelangt, kann die Schutzflüssigkeit auf die Oberseite aufgebracht werden, ehe das Substrat unterseitig mit der Behandlungsflüssigkeit benetzt wird. Auf diese Weise kann die Menge der in die Behandlungsflüssigkeit eingetragenen Schutzflüssigkeit verringert werden. Wie in WO 2011/047894 A1 bereits dargelegt wird, kann aber selbst dann ein Herabtropfen von Schutzflüssigkeit in das Behandlungsmedium, beziehungsweise die Behandlungsflüssigkeit, nicht verhindert werden. Wird als Schutzflüssigkeit Wasser verwendet, hat dies eine Verdünnung der Behandlungsflüssigkeit und somit einen erhöhten Chemikalienverbrauch zur Folge. Zudem ist ein erhöhter Verfahrensaufwand erforderlich, um konstante Behandlungsbedingungen, beispielsweise eine konstante Zusammensetzung der Behandlungsflüssigkeit, und damit Prozesssicherheit zu gewährleisten. Wird ein anderes Material als Behandlungsflüssigkeit eingesetzt, so kommt es für gewöhnlich zu einer Kontamination des Behandlungsmediums mit ähnlichen und meist noch aufwändiger zu beherrschenden Folgen.

Weiterhin kann es an denjenigen Stellen, an welchen Schutzflüssigkeitstropfen von der Oberseite aus über Kanten des Substrats herablaufen und herabtropfen, zu einer Schlierenbildung während des Behandelns mit dem Behandlungsmedium kommen. Dies ist darauf zurückzuführen, dass an diesen Stellen die Unterseite des Substrats weniger stark geätzt wird. Diese Problematik tritt insbesondere auf, wenn als Behandlungsmedium eine Ätzlösung eingesetzt wird, mittels welcher ein vergleichsweise starker Materialabtrag von der Unterseite des Substrats vorgenommen wird. Ein derart starkes einseitiges Ätzen ist insbesondere bei neuen Siliziumsolarzellenherstellungsverfahren erforderlich, beispielsweise bei Verfahren zur Herstellung von Solarzellen mit passiviertem Emitter und passivierten Rückkontakten, den sogenannten PERC-Solarzellen. Infolge der geschilderten Ungleichheiten beim Ätzen ergibt sich ein inhomogenes Erscheinungsbild der Unterseite des Substrats und damit, neben eventuellen elektrischen Beeinträchtigungen des Halbleiterbauelements, ein inhomogenes Erscheinungsbild der fertigen Solarzelle. Zudem können in nachfolgenden Prozessschritten Probleme entstehen. So kann beispielsweise eine inhomogene Dicke einer auf der Unterseite des Substrats angeordnete Oxidschicht dazu führen, dass ein nachfolgend auf der Unterseite des Substrats durchgeführter Ätzschritt zu verschiedenen Zeiten beginnt.

Darüber hinaus besteht bei der bekannten Verfahrensweise die Gefahr, dass eine als Behandlungsmedium eingesetzte, die Unterseite des Substrats benetzende Behandlungsflüssigkeit infolge eines Konzentrationsgefälles oder aufgrund von Benetzungsphänomenen über die Kanten des Substrats kriecht und auf diese Weise auf die Oberseite des Substrats gelangt. Dort kann sie die Oberfläche des Substrats lokal oder flächig beschädigen, beispielsweise infolge einer Ätzwirkung.

Vor diesem Hintergrund liegt der vorliegenden Erfindung die Aufgabe zu Grunde, ein Verfahren zum unterseitigen Behandeln eines flächigen Substrats zur Verfügung zu stellen, mittels welchem zumindest ein Teil der geschilderten Nachteile aufwandsgünstig überwunden werden kann.

Diese Aufgabe wird gelöst durch ein Verfahren mit den Merkmalen des Anspruchs 1.

Weiterhin liegt der vorliegenden Erfindung die Aufgabe zu Grunde, eine Vorrichtung zur Verfügung zu stellen, mittels welcher dieses Verfahren durchgeführt und die Gefahr einer Schädigung der Oberseite des Substrats weitergehend verringert werden kann.

Diese Aufgabe wird gelöst durch eine Vorrichtung mit den Merkmalen des nebengeordneten unabhängigen Anspruchs. Vorteilhafte Weiterbildungen sind jeweils Gegenstand abhängiger Unteransprüche.

Das erfindungsgemäße Verfahren sieht vor, dass zum Zwecke des unterseitigen Behandelns eines flächigen Substrats mit einem Behandlungsmedium, zunächst eine Unterseite des Substrats mittels einseitigen, nasschemischen Ätzens hydrophobiert wird. Nachfolgend wird auf einer Oberseite des Substrats ein Schutzflüssigkeitsfilm ausgebildet. Danach wird das Behandlungsmedium mit der Unterseite des Substrats in Kontakt gebracht und dabei die Oberseite mittels des Schutzflüssigkeitsfilms gegen ein Einwirken des Behandlungsmediums und/oder dessen Ausgasungen geschützt.

Infolge der Hydrophobierung gelangt bei dieser Vorgehensweise nach der Entnahme des Substrats aus der Schutzflüssigkeit keine Schutzflüssigkeit von der Oberseite auf die Unterseite des Substrats. Die oben geschilderte Problematik der Schlierenbildung und die hieraus resultierenden Nachteile können daher vermieden werden. Darüber hinaus kann verhindert werden, dass Behandlungsmedium, wie oben beschrieben, von der Unterseite auf die Oberseite kriecht. Dies ist insbesondere bei schwefelsäurefreien Behandlungsmedien von Vorteil. Überdies kann durch die Hydrophobierung in vielen Anwendungsfällen ein Trocknungsschritt eingespart werden, der bei bislang bekannten Verfahren vor einem weiteren Prozessschritt erforderlich wäre. Des Weiteren kann das Verfahren als Durchlaufverfahren konzipiert werden und ist einfach in bereits bestehende Durchlaufanlagen integrierbar.

Eine Hydrophobierung im Sinne der vorliegenden Erfindung ist gegeben, wenn die Schutzflüssigkeit die hydrophobierte Fläche mit einem Kontaktwinkel größer als 60° benetzt.

Mittels der Schutzflüssigkeit kann die Oberseite grundsätzlich gegen das Behandlungsmedium an sich, welches insbesondere als Flüssigkeit oder Gas beziehungsweise Gasgemenge vorliegen kann, geschützt werden. Wird eine Behandlungsflüssigkeit eingesetzt, so wird der Schutzflüssigkeitsfilm vorzugsweise sowohl als Schutz gegenüber auf die Oberseite gelangende Behandlungsflüssigkeit als auch als Schutz gegen auf die Oberseite des Substrats gelangende Ausgasungen aus der Behandlungsflüssigkeit verwendet. Solche Ausgasungen können beispielsweise durch ein teilweises Verdampfen der Behandlungsflüssigkeit entstehen.

Vorzugsweise wird als Schutzflüssigkeit Wasser verwendet, besonders bevorzugt deionisiertes Wasser. Dieses hat sich in vielen Anwendungsfällen bewährt und kann meistens vergleichsweise einfach aufbereitet oder entsorgt werden.

Vorteilhafterweise wird ein Siliziumsubstrat behandelt und zum Zwecke des Hydrophobierens der Unterseite dieses Siliziumsubstrats eine Silikatglasschicht, beispielsweise eine Phosphor- oder eine Borsilikatglasschicht, von der Unterseite des Siliziumsubstrats entfernt. Derartige Silikatglasschichten werden bei der Herstellung von Halbleiterbauelementen häufig eingesetzt, insbesondere bei der Herstellung von Siliziumsolarzellen, sodass dies eine besonders aufwandsgünstige Verfahrensführung ermöglicht. Zudem kann für die Hydrophobierung des Siliziumsubstrats auf bewährte Techniken zurückgegriffen werden.

Bei einer Ausführungsvariante des Verfahrens wird zum Zwecke des Ausbildens des Schutzflüssigkeitsfilms mittels einer Auftragvorrichtung eine Schutzflüssigkeit auf die Oberseite des Substrats aufgebracht. Als Auftragvorrichtung können grundsätzlich alle an sich bekannten Auftragvorrichtungen wie beispielsweise Sprühdüsen verwendet werden. Vorzugsweise wird wenigstens ein Schwallrohr als Auftragvorrichtung eingesetzt.

Eine alternative Ausführungsvariante sieht vor, das Substrat zum Zwecke des Ausbildens des Schutzflüssigkeitsfilms in die Schutzflüssigkeit einzutauchen und aus dieser zu entnehmen. Bei der Entnahme des Substrats aus der Schutzflüssigkeit wird das Substrat derart ausgerichtet, dass es sich in einer im Wesentlichen horizontal verlaufenden Ebene erstreckt, sodass auf einer Oberseite des Substrats der gewünschte Schutzflüssigkeitsfilm verbleibt. Dass das Substrat bei der Entnahme aus der Schutzflüssigkeit derart ausgerichtet wird, dass es sich in einer im Wesentlichen horizontal verlaufenden Ebene erstreckt, ist dahingehend zu verstehen, dass geringfügige Abweichungen von der Horizontalen kurzzeitig möglich sind. Wie lange von der Horizontalen abgewichen werden kann und in welchem exakten Umfang, hängt von den Eigenschaften verwendeter Materialien ab, insbesondere von einer Viskosität der Schutzflüssigkeit und Adhäsionskräften zwischen der Oberseite des Substrats und der Schutzflüssigkeit. Aufwändige Auftragsvorrichtungen wie Sprühdüsen, Schwallrohre oder anderes sind bei dieser Ausführungsvariante nicht erforderlich. Auch bedarf es keiner Dosierungsvorrichtungen und Messeinrichtungen, die erforderlich wären, um die Position des Substrats zu bestimmen und zum richtigen Zeitpunkt eine exakte Dosierung von Schutzflüssigkeit auf die Oberseite des Substrats zu gewährleisten und auf diese Weise die Menge der von der Oberseite des Substrats herab laufenden Schutzflüssigkeit einzugrenzen.

Bevorzugt werden vor dem Eintauchen des Substrats in die Schutzflüssigkeit die Kanten des Substrats ebenfalls, vorzugsweise vollständig, hydrophobiert. Dies erfolgt vorteilhafterweise in einem gemeinsamen Verfahrensschritt mit dem Hydrophobieren der Unterseite des Substrats. Das heißt, dass die Unterseite und die Kanten des Substrats gleichzeitig in einem einheitlichen Verfahrensschritt hydrophobiert werden. Mittels der hydrophobierten Kanten kann die Gefahr des Kriechens von Behandlungsflüssigkeit auf die Oberseite des Substrats, die grundsätzlich bestehen kann, wenn die Behandlungsflüssigkeit aus irgendeinem Grund mit nicht hydrophobierten Kantenteilen in Kontakt gerät, nochmals verringert werden.

Die Unterseite des Substrats kann vorteilhaft mittels einseitigen, nasschemischen Ätzens hydrophobiert werden. Einseitig bedeutet in diesem Zusammenhang, dass an die Oberseite keine für das nasschemische Ätzen verwendete Ätzlösung herangeführt wird. Auf diese Weise können Anlagen eingesetzt werden, die sich in der Praxis bereits in anderem Zusammenhang bewährt haben. Überdies können bei dieser Verfahrensvariante die Kanten in demselben Verfahrensschritt aufwandsgünstig ganz oder teilweise ebenfalls hydrophobiert werden.

Besonders bevorzugt wird zum Zwecke des Hydrophobierens der Unterseite des Substrats das Substrat von unten mit einer Ätzflüssigkeit benetzt. Dies ermöglicht eine Hydrophobierung in industriellem Maßstab, unter anderem in Durchlaufanlagen. Insbesondere kann das Substrat quasi schwimmend an der Oberfläche der Ätzflüssigkeit derart durch ein Ätzbecken geführt werden, dass die Ätzflüssigkeit die Unterseite des Substrats benetzt. Grundsätzlich kann die Ätzflüssigkeit jedoch auch auf eine beliebige andere Weise an die Unterseite des Substrats herangeführt werden, beispielsweise mittels Transportrollen, welche die Ätzflüssigkeit aufnehmen und an die auf ihnen transportierten Substrate weiterreichen. Die Kanten können bei diesen Verfahrensvarianten vorteilhafterweise ganz oder teilweise ebenfalls hydrophobiert werden.

Vorteilhafterweise wird nach dem zum Zwecke des Hydrophobierens vorgenommenen nasschemischen Ätzen das Substrat gespült. Bei einer Verfahrensvariante erfolgt dies, indem eine Spülflüssigkeit auf das Substrat aufgebracht wird, beispielsweise mittels eines Schwallrohres oder einer anderen Auftragvorrichtung. Die Menge der auf das Substrat aufgebrachten Spülflüssigkeit wird dabei derart gewählt, dass mindestens die Hälfte, vorzugsweise mindestens 70 % und besonders bevorzugt mindestens 80 %, der aufgebrachten Menge an Spülflüssigkeit von dem Substrat abtropft und verbliebene Ätzflüssigkeitsreste abspült. Die letztlich auf der Oberseite verbleibende Spülflüssigkeit wird im Weiteren als Schutzflüssigkeitsfilm verwendet, sodass es für dessen Ausbildung keines zusätzlichen Verfahrensschrittes bedarf.

Eine alternative Verfahrensvariante sieht vor, dass das Substrat zum Zwecke des Spülens in eine Spülflüssigkeit eingetaucht und diese Spülflüssigkeit gleichzeitig als Schutzflüssigkeit verwendet wird. Eine Entnahme des Substrats aus der Spülflüssigkeit stellt sodann gleichzeitig die Entnahme des Substrats aus der Schutzflüssigkeit dar. Das Substrat wird bei der Entnahme aus der Schutzflüssigkeit in der oben beschriebenen Weise derart ausgerichtet, dass es sich in einer im Wesentlichen horizontal verlaufenden Ebene erstreckt, sodass auf der Oberseite des Substrats der Schutzflüssigkeitsfilm verbleibt. Auf diese Weise kann das Verfahren besonders schnell und aufwandsgünstig realisiert werden.

Als Spülflüssigkeit kann grundsätzlich jede für den jeweiligen Anwendungsfall geeignete Flüssigkeit verwendet werden. Vorzugsweise wird Wasser verwendet und bei der Herstellung von Halbleiterbauelementen wie beispielsweise Solarzellen aus Kontaminationsgründen besonders bevorzugt deionisiertes Wasser.

In einer bewährten Verfahrensvariante wird als Behandlungsmedium ein Ätzmedium verwendet und die Unterseite des Substrats mittels dieses Ätzmediums geätzt. Bei diesem Ätzen kann ein Materialabtrag erfolgen. Beispielsweise kann es sich um ein Politurätzen handeln. Insbesondere kann die Unterseite eines Siliziumsolarzellensubstrats geätzt werden. Diese Verfahrensvariante hat sich daher insbesondere bei der Herstellung von neuartigen, hocheffizienten Solarzellen mit passivierten Emittern und passivierten Rückkontakten bewährt.

Vorteilhafterweise wird zum Zwecke des Ausbildens des Schutzflüssigkeitsfilms die Schutzflüssigkeit mehrmals auf die Oberseite des Substrats aufgebracht. Das heißt, dass die Schutzflüssigkeit in mehreren, mit zeitlichem Versatz ablaufenden Auftragsvorgängen aufgebracht wird. Beispielsweise beginnt ein zweiter Auftragsvorgang nachdem ein erster Auftragsvorgang bereits begonnen wurde oder nachdem der erste Auftragsvorgang beendet wurde. Vorzugsweise beginnt der zweite Auftragsvorgang nachdem der erste Auftragsvorgang beendet wurde.

Es hat sich gezeigt, dass mittels des mehrmaligen Aufbringens der Schutzflüssigkeit die Schutzflüssigkeit besser auf der Oberseite des Substrats verteilt werden kann. Insbesondere hat sich gezeigt, dass die Schutzflüssigkeit in diversen Anwendungsfällen besser in Ecken des Substrats und an Randbereiche des Substrats gelangen kann. Die Gefahr einer Bildung von Inseln aus Schutzflüssigkeit auf der Oberseite des Substrats, welche Teile der Oberseite des Substrats unbedeckt lassen, wird verringert oder gar vermieden. Je nach Anwendungsfall kann daher die insgesamt auf die Oberseite des Substrats zum Zwecke der Ausbildung des Schutzflüssigkeitsfilms aufgebrachte Menge an Schutzflüssigkeit verringert werden, ohne dass dies mit einer erhöhten Gefahr von nicht mit dem Schutzflüssigkeitsfilm bedeckter Teilbereiche der Oberseite des Substrats einhergeht. Insbesondere bei der oben beschriebenen Verfahrensvariante, bei welcher das Substrat in eine Schutzflüssigkeit eingetaucht und bei der Entnahme derart ausgerichtet wird, dass auf der Oberseite des Substrats der Schutzflüssigkeitsfilm verbleibt, kann das beschriebene mehrmalige Aufbringen der Schutzflüssigkeit zudem dazu dienen, den Schutzflüssigkeitsfilm zu verstärken oder zu vervollständigen. Dies kann in einzelnen Anwendungsfällen vorteilhaft sein, beispielsweise wenn bei einer ungünstigen Verfahrensführung während der Entnahme des Substrats aus der Schutzflüssigkeit zu viel Schutzflüssigkeit von der Oberseite des Substrats herunterläuft oder im weiteren Verfahrensverlauf zu viel Schutzflüssigkeit aus dem Schutzflüssigkeitsfilm verdampft. Nebenbei sei bemerkt, dass die oben beschriebene horizontale Entnahme des Substrats aus der Schutzflüssigkeit und das damit einhergehende Verbleiben eines Schutzflüssigkeitsfilms auf der Oberseite des Substrats ein Aufbringen von Schutzflüssigkeit auf die Oberseite des Substrats darstellt.

Die erfindungsgemäße Vorrichtung weist ein Vorkonditionierungsbecken auf, welches eine Flüssigkeit enthält, mittels welcher zu behandelnde Substrate hydrophobiert werden können. In einer Transportrichtung der Substrate dem Vorkonditionierungsbecken nachgeordnet ist ein Spülbecken vorgesehen. Dieses kann ein Spülmedium enthalten oder dazu vorgesehen sein, abtropfende Spülflüssigkeit aufzufangen. Weiterhin ist ein in der Transportrichtung der Substrate dem Spülbecken nachgeordnetes Behandlungsbecken vorgesehen, welches eine Behandlungsflüssigkeit enthält. In dem Vorkonditionierungsbecken sind Transportrollen vorgesehen, welche zum Transport der Substrate durch das Vorkonditionierungsbecken geeignet sind. Diese Transportrollen sind mehrheitlich, vorzugsweise ausschließlich, als plateaulose Strukturrollen ausgeführt.

Unter plateaulosen Strukturrollen sind vorliegend Transportrollen zu verstehen, welche an ihrer Oberfläche ringförmige Ausnehmungen, sogenannte Einstiche, aufweisen, welche die Transportrolle umfänglich umschließen. Diese Ausnehmungen sind unmittelbar aneinander angrenzend auf der Transportrolle angeordnet. An denjenigen Stellen, an welchen die Ausnehmungen aneinandergrenzen, stoßen die Wandungen benachbarter Ausnehmungen aufeinander und bilden erhabene Bereiche auf der Transportrollenoberfläche aus. Im Fall von plateaulosen Strukturrollen sind die benachbarten Ausnehmungen derart nah aneinander angrenzend angeordnet, dass diese erhabenen Bereiche keine Plateaus mehr darstellen, sondern vielmehr als eine Art Spitzen angesehen werden können. Mittels plateauloser Strukturrollen kann eine gleichmäßige Benetzung der Unterseite des Substrats realisiert werden. Bei dem Ätzvorgang entstehende Blasen werden homogen über die Substratunterseite verteilt und immer wieder abgestreift. Dies ermöglicht, vor allem bei hohen Ätzraten, ein homogeneres Ätzergebnis. Ferner hat sich gezeigt, dass bei einer Verwendung von plateaulosen Strukturrollen die Gefahr, dass eine Transportrolle die hydrophobierende Flüssigkeit oder eine andere Behandlungsflüssigkeit in dem Moment, in welchem das Substrat diese Transportrolle verlässt, auf die Oberseite dieses Substrats befördert, gegenüber Vollrollen erheblich verringert ist. Die Verwendung plateauloser Strukturrollen in dem Vorkonditionierungsbecken ermöglicht somit eine weitergehende Verringerung der Gefahr der Schädigung der Oberseite des Substrats.

Vorteilhafterweise sind in dem Spülbecken zum Transport der Substrate mehrheitlich O-Ring-Rollen, welche jeweils ein Wellenelement sowie mehrere in Längsrichtung des Wellenelements voneinander beabstandete O-Ring-Aufnahmen aufweisen, als Transportrollen vorgesehen. In den genannten O-Ring-Aufnahmen ist jeweils ein O-Ring angeordnet ist, welcher das Wellenelement sowie die jeweilige O-Ring-Aufnahme umfänglich umschließt. In einer verschlechterten Ausführungsform können anstelle von O-Ring-Aufnahmen und darin angeordneten O-Ringen Ausformungen des Wellenelements vorgesehen sein.

Vorzugsweise sind in dem Spülbecken ausschließlich die beschriebenen O-Ring-Rollen als Transportrollen angeordnet. Auf diese Weise wird die Kontaktfläche zwischen Transportrolle und darauf transportiertem Substrat minimiert. Infolgedessen kann noch an dem Substrat anhaftende, hydrophobierende Flüssigkeit aus dem Vorkonditionierungsbecken besser weggespült werden. O-Ring-Rollen haben eine sehr geringe Neigung Flüssigkeit auf die Oberseiten der Substrate zu befördern, wenn das Substrat die O-Ring-Rolle verlässt. Dennoch ist ihre Verwendung in dem Vorkonditionierungsbecken oder dem Behandlungsbecken nicht vorteilhaft, da sie Rollenspuren hinterlassen, welche dem Ziel eines homogenen Ätzergebnisses entgegenwirken. Wie sich herausgestellt hat, überwiegen im Spülbecken jedoch die Vorteile der äußerst geringen Gefahr einer Schädigung der Substratoberseiten durch auf die Oberseite geschaufelte Flüssigkeit.

Vorteilhafterweise sind in dem Behandlungsbecken zum Transport der Substrate durch das Behandlungsbecken mehrheitlich, vorzugsweise ausschließlich, plateaulose Strukturrollen als Transportrollen vorgesehen. Die bereits im Zusammenhang mit dem Vorkonditionierungsbecken beschriebenen Wirkungen der plateaulosen Strukturrollen wirken sich im Behandlungsbecken ebenfalls vorteilhaft aus und ermöglichen eine weitergehende Verringerung der Gefahr einer Schädigung der Oberseite der behandelten Substrate.

Als hydrophobierende Flüssigkeit kann in dem Vorkonditionierungsbecken eine flusssäurehaltige Ätzlösung vorgesehen sein. Diese hat sich insbesondere bei der Entfernung von Silikatglasschichten von Siliziumsubstraten bewährt.

Als Behandlungsflüssigkeit kann eine Ätzlösung vorgesehen sein, welche Flusssäure und ein Oxidationsmittel, vorzugsweise Salpetersäure oder Wasserstoffperoxid, enthält. In einer anderen Ausgestaltungsvariante kann als Behandlungsflüssigkeit eine Ätzlösung vorgesehen sein, welche neben der genannten Flusssäure und dem genannten Oxidationsmittel zusätzlich ein Additiv, vorzugsweise Schwefelsäure, enthält. Beide Varianten haben sich insbesondere bei der Behandlung von Siliziumsubstraten bewährt.

Vorteilhafterweise sind mehrere Auftragvorrichtungen vorgesehen, mittels welchen eine Schutzflüssigkeit auf eine Oberseite der Substrate aufbringbar ist. Diese mehreren Auftragvorrichtungen sind in der Transportrichtung der Substrate versetzt zueinander angeordnet. Dies ermöglicht es, wie oben beschrieben, Schutzflüssigkeit mehrmals auf die Oberseite der Substrate aufzubringen.

Vorzugsweise ist wenigstens eine der mehreren Auftragvorrichtungen über dem Spülbecken angeordnet. Eine Auftragvorrichtung kann beispielsweise aus einem Schwallrohr oder dergleichen gebildet sein oder aus Transportrollen, mittels welchen die Substrate vollständig in eine in dem Spülbecken angeordnete Spülflüssigkeit eingetaucht durch zumindest einen Teil des Spülbeckens transportiert werden.

Es hat sich als vorteilhaft erwiesen, dass wenigstens eine der mehreren Auftragvorrichtungen in der Transportrichtung der Substrate nach dem Spülbecken angeordnet ist. Auf diese Weise können zwischenzeitlich erfolgte Verluste an Schutzflüssigkeit auf der Oberseite der Substrate, beispielsweise infolge von Verdampfungseffekten, komfortabel ausgeglichen werden.

Vorteilhafterweise ist wenigstens eine der mehreren Auftragvorrichtungen über dem Behandlungsbecken angeordnet. Auf diese Weise können Verdampfungsverluste oder Fehlmengen an Schutzflüssigkeit auf der Oberseite der Substrate während des Einwirkens der Behandlungsflüssigkeit kompensiert werden. Die Gefahr, dass erneut Fehlmengen oder Verdampfungsverluste an der Schutzflüssigkeit entstehen, wird auf diese Weise minimiert.

Im Weiteren wird die Erfindung anhand von Figuren näher erläutert. Soweit zweckdienlich, sind hierin gleich wirkende Elemente mit gleichen Bezugszeichen versehen. Die Erfindung ist nicht auf die in den Figuren dargestellten Ausführungsbeispiele beschränkt - auch nicht in Bezug auf funktionale Merkmale. Die bisherige Beschreibung wie auch die nachfolgende Figurenbeschreibung enthalten zahlreiche Merkmale, die in den abhängigen Unteransprüchen teilweise zu mehreren zusammengefasst wiedergegeben sind. Diese Merkmale wie auch alle übrigen oben und in der nachfolgenden Figurenbeschreibung offenbarten Merkmale wird der Fachmann jedoch auch einzeln betrachten und zu sinnvollen weiteren Kombinationen zusammenfügen. Insbesondere sind diese Merkmale jeweils einzeln und in beliebiger geeigneter Kombination mit dem Verfahren und/oder der Vorrichtung der unabhängigen Ansprüche kombinierbar. Es zeigen:
- Figur 1: Ein erstes Ausführungsbeispiel des erfindungsgemäßen Verfahrens sowie der erfindungsgemäßen Vorrichtung in einer schematischen Darstellung
- Figur 2: Seitenansicht einer plateaulosen Strukturrolle aus Figur 1
- Figur 3: Detaildarstellung eines Teilbereichs A aus Figur 2
- Figur 4: Schematische Darstellung einer O-Ring-Rolle
- Figur 5: Ein zweites Ausführungsbeispiel des erfindungsgemäßen Verfahrens sowie der erfindungsgemäßen Vorrichtung in einer schematischen Darstellung
- Figur 6: Ein drittes Ausführungsbeispiel des erfindungsgemäßen Verfahrens sowie der erfindungsgemäßen Vorrichtung in einer schematischen Darstellung

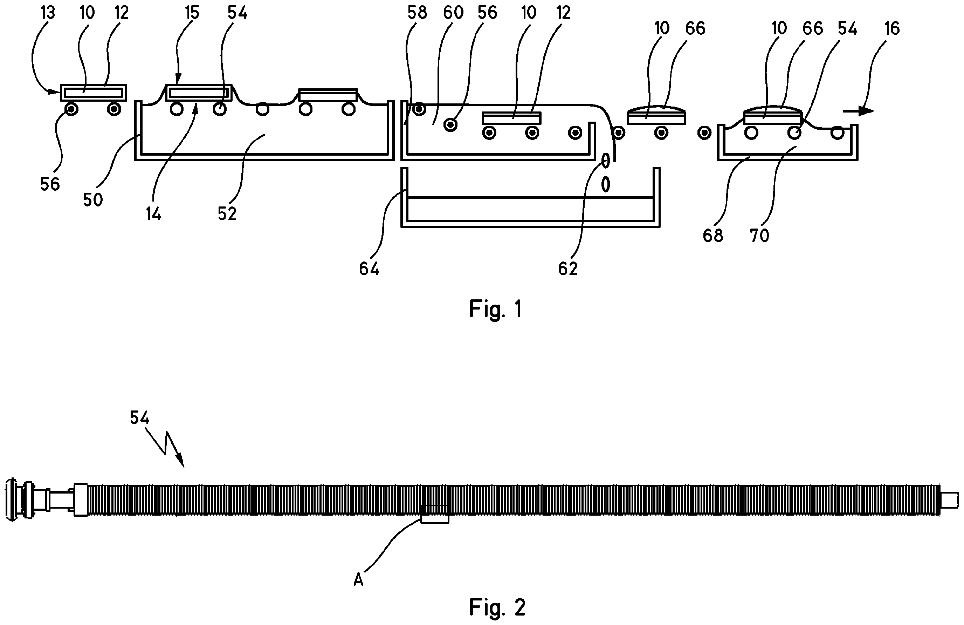

Figur 1 illustriert in einer schematischen Darstellung ein Ausführungsbeispiel des erfindungsgemäßen Verfahrens wie auch der erfindungsgemäßen Vorrichtung. Bei diesem Ausführungsbeispiel wird ein Siliziumsubstrat 10, welches an seiner gesamten Oberfläche mit einer Phosphorsilikatglasschicht 12 versehen ist, beispielsweise infolge einer Phosphordiffusion, mittels Transportrollen in einer Transportrichtung 16 durch eine Abfolge verschiedener Becken transportiert. Zunächst werden in einem Vorkonditionierungsbecken 50 eine Unterseite 14 sowie die Kanten 13 des Substrats 10 hydrophobiert. Zu diesem Zweck wird die Unterseite 14 des Substrats 10 von unten mit einer hydrophobierenden Flüssigkeit 52, im vorliegenden Ausführungsbeispiel mit einer flusssäurehaltigen Ätzlösung, benetzt. Im Vorkonditionierungsbecken sind ausschließlich plateaulose Strukturrollen 54 als Transportrollen vorgesehen, welche ein homogenes Ätzen ermöglichen. Im Ergebnis wird die Phosphorsilikatglasschicht 12 gleichmäßig an der Unterseite 14 sowie den Kanten 13 entfernt.

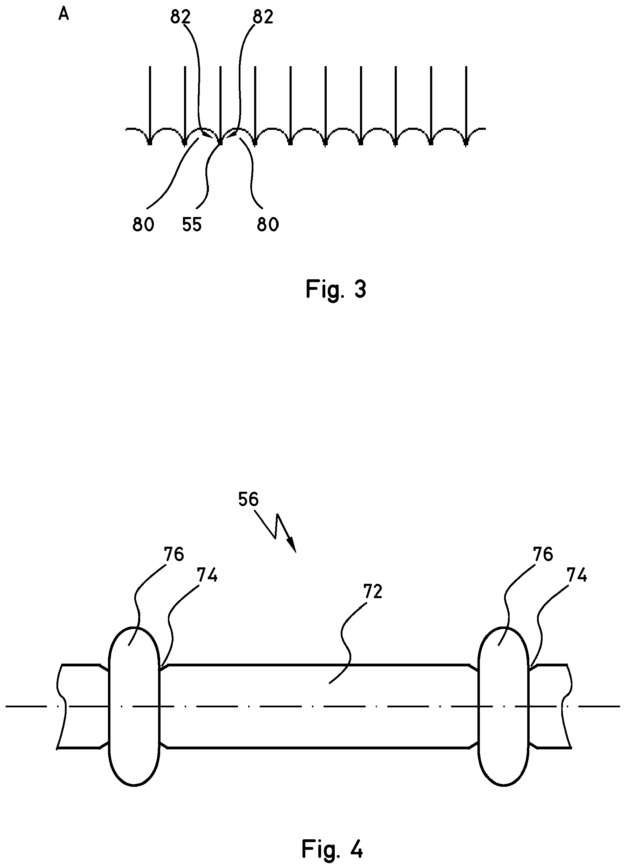

Eine Seitenansicht der im Ausführungsbeispiel der Figur 1 verwendeten plateaulosen Strukturrollen 54 findet sich in Figur 2. Eine vergrößerte Darstellung des Teilbereichs A ist in Figur 3 wiedergegeben. Hierin sind tief eingestochene Ausnehmungen 80 erkennbar, welche unmittelbar aneinander angrenzend auf der Strukturrolle 54 angeordnet sind und erhabene Bereiche ausbilden. Wandungen 82 zweier benachbarter Ausnehmungen 80 sind dabei derart nah aneinander angrenzend angeordnet, dass diese erhabenen Bereiche kein Plateau aufweisen, sondern vielmehr die Gestalt einer Spitze 55. Die plateaulosen Strukturrollen 54 ermöglichen, wie oben erläutert, im Vorkonditionierungsbecken 50 ein homogenes Ätzen der Unterseite 14 des Substrats 10 bei vergleichsweise geringer Gefahr einer unerwünschten lokalen Hydrophobierung der Oberseite 15 in Folge von auf die Oberseite 15 geschaufelter, hydrophobierende Flüssigkeit 52.

Im Weiteren Verfahrensverlauf wird das Substrat 10 in ein Spülbecken 58 transportiert, welches als Spülmedium deionisiertes Wasser 60 enthält. Dort wird es in das als Spülflüssigkeit dienende deionisierte Wasser 60 eingetaucht. Das deionisierte Wasser 60 wird dabei gleichzeitig als Schutzflüssigkeit verwendet. Der Transport des Substrats 10 im Spülbecken 58 erfolgt mittels O-Ring-Rollen 56, welche die Auflagefläche für das Substrat minimieren und auf diese Weise einen effizienten Spülvorgang ermöglichen. Aus dem Spülbecken 58 überlaufendes Wasser 62 wird in einem Überlaufbecken 64 aufgefangen.

Eine schematische Darstellung eines Abschnitts der O-Ring-Rolle 56 zeigt Figur 4. Die O-Ring-Rolle 56 weist ein Wellenelement 72 auf sowie in Längsrichtung des Wellenelements 72 voneinander beabstandete O-Ring-Aufnahmen, welche im Fall des vorliegenden Beispiels als Ausnehmungen 74 in dem Wellenelement 72 ausgeführt sind, in welchen jeweils ein O-Ring 76 angeordnet ist. Der in Figur 4 dargestellte Abschnitt der O-Ring-Rolle 56 weist zwei O-Ringe 76 auf. Diese Zahl ist grundsätzlich für den Transport des flächigen Substrats 10 ausreichend. Je nach Bedarf kann, beispielsweise bei größeren oder zerbrechlichen Substraten, eine größere Anzahl von O-Ringen vorgesehen werden.

Wird das Substrat 10 mittels der O-Ring-Wellen 56 in der Transportrichtung 16 weitertransportiert, so wird es auf diese Weise aus dem Spülbecken 58 entnommen. Das Substrat 10 erstreckt sich dabei in einer horizontal verlaufenden Ebene. Die O-Ring-Rollen 56 sind zu diesem Zweck entsprechend ausgerichtet. Die zuvor hydrophobierten Kanten 13 sowie die hydrophobierte Unterseite 14 sind nach der Entnahme des Substrats 10 aus dem Spülbecken 58 frei von deionisiertem Wasser 60. Auf der Oberseite 15 hingegen verbleibt ein Schutzflüssigkeitsfilm 66 aus deionisiertem Wasser 60. Die auf der Oberseite 15 des Substrats 10 verbliebene, hydrophile Phosphorsilikatglasschicht 12 begünstigt die Ausbildung des Schutzflüssigkeitsfilms 66 zusätzlich, wobei Hydrophilie im vorliegenden Sinne ein Kontaktwinkel zwischen Oberfläche und benetzender Flüssigkeit von weniger als 15° zu verstehen ist. Die Hydrophilie der Oberseite 15 wirkt zudem einem Herablaufen von deionisiertem Wasser aus dem Schutzflüssigkeitsfilm 66 zusätzlich entgegen.

Nachfolgend wird das Substrat 10 in ein Behandlungsbecken 60 transportiert, welches eine Ätzlösung 70 enthält. Als Ätzlösung ist im vorliegenden Ausführungsbeispiel eine Flusssäure und Salpetersäure enthaltende Ätzlösung 70 vorgesehen. Alternativ kann unter anderem eine Ätzlösung verwendet werden, welche neben Flusssäure und Salpetersäure Schwefelsäure enthält. Indem das Substrat mittels der plateaulosen Strukturrollen 54 durch das Behandlungsbecken 68 transportiert wird, wird die Ätzlösung 70 mit der Unterseite 14 des Substrats in Kontakt gebracht und geätzt. Die Oberseite 15 des Substrats 10 ist hingegen durch den Schutzflüssigkeitsfilm 66 gegen auf die Oberseite 15 gelangende Ätzlösung 70 und gegen eine Einwirkung von Ausgasungen aus der Ätzlösung 70, insbesondere gegen ätzende Dämpfe, geschützt. Die Unterseite 14 wird geätzt, ohne dass die empfindliche Oberseite 15 des Substrats 10 beeinträchtigt wird. Ein Herablaufen von deionisiertem Wasser aus dem Schutzflüssigkeitsfilm 66 oder ein Kriechen von Ätzlösung 70 auf die Oberseite 15 des Substrats 10 ist unterbunden. Es kommt zu keiner Schlierenbildung auf der Unterseite 14 des Substrats 10 und die Ätzlösung 70 wird nicht durch von der Oberseite 15 des Substrats 10 herablaufende Teile des Schutzflüssigkeitsfilms 66 kontaminiert beziehungsweise verdünnt. Die oben beschriebenen Vorteile der plateaulosen Strukturrollen 54 wirken sich auch im Behandlungsbecken positiv aus, sodass die Gefahr einer Schädigung der Oberseite 15 des Substrats 10 durch die ausschließliche Verwendung plateauloser Strukturrollen 54 weiter verringert wird.

Eine Verweildauer der Substrate 10 in dem Vorkonditionierungsbecken 50 ist so zu wählen, dass die Phosphorsilikatglasschicht 12 mit Sicherheit von der Unterseite 14 des Substrats 10 entfernt wird. Die Länge des Vorkonditionierungsbeckens 50 ist gegebenenfalls entsprechend anzupassen. Die Substrate können jedoch nicht beliebig lange der hydrophobierenden Flüssigkeit 52 ausgesetzt werden. Andernfalls kann es dazu kommen, dass die hydrophobierende Flüssigkeit 52 auf die Oberseite 15 des Substrats 10 kriecht und diese oder darunter liegende Schichten in erheblichem Umfang schädigt. Die Verweildauer der Substrate im Vorkonditionierungsbecken 50, beziehungsweise die Länge dieses Beckens, sind daher entsprechend zu wählen. Im Übrigen kann es je nach Dicke der Phosphorsilikatglasschicht 12 oder in Abhängigkeit von Materialeigenschaften und Dicken anderer zu entfernender Schichten vorteilhaft sein, angepasste Transportrollen zu verwenden. Beispielsweise können tiefer oder weniger tief eingestochene plateauloses Strukturrollen Verwendung finden.

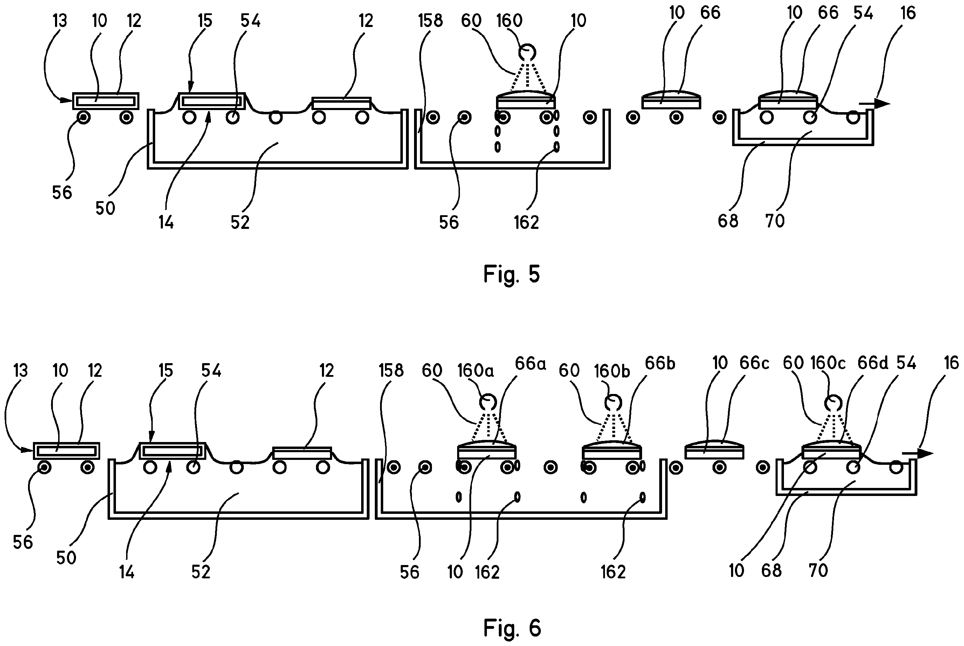

Figur 5 illustriert in einer schematischen Darstellung ein zweites Ausführungsbeispiel des erfindungsgemäßen Verfahrens sowie der erfindungsgemäßen Vorrichtung. Dieses unterscheidet sich von dem ersten Ausführungsbeispiel der Figur 1 dadurch, dass anstelle des Spülbeckens 58 ein Spülbecken 158 vorgesehen ist, welches Spülflüssigkeit auffängt. Zum Zwecke des Spülens ist ein Schwallrohr 160 vorgesehen, mittels welchem das als Spülflüssigkeit verwendete, deionisierte Wasser 60 auf die Oberseite 15 der Siliziumsubstrate aufgebracht wird. Das deionisierte Wasser 60 wird in solch einer Menge aufgebracht, dass über die Kanten 13 der Siliziumsubstrate 10 herabtropfendes Wasser 162 die Siliziumsubstrate spült. Ist das Siliziumsubstrat 10 unter dem Schwallrohr 160 durchgelaufen verbleibt auf der Oberseite 15 der Siliziumsubstrate 10 ein Film aus deionisiertem Wasser, welcher als Schutzflüssigkeitsfilm 66 verwendet wird. Ist ein Spülen der Substrate nicht erforderlich, so kann mittels des Schwallrohres 160 das deionisierte Wasser, oder eine andere geeignete Schutzflüssigkeit, grundsätzlich derart dosiert auf die Oberseite 15 der Siliziumsubstrate 10 aufgebracht werden, dass der Schutzflüssigkeitsfilm 66 ausgebildet wird, aber nur möglichst wenig Schutzflüssigkeit über die Kanten 13 der Siliziumsubstrate 10 läuft und in das Spülbecken 158 tropft.

Figur 6 illustriert in einer schematischen Darstellung ein drittes Ausführungsbeispiel des erfindungsgemäßen Verfahrens sowie der erfindungsgemäßen Vorrichtung. Dieses unterscheidet sich von dem in Figur 5 dargestellten, zweiten Ausführungsbeispiel unter anderem dadurch, dass neben einem Schwallrohr 160a ein weiteres Schwallrohr 160b vorgesehen ist, welches in der Transportrichtung 16 der Substrate 10 nach dem Schwallrohr 160a angeordnet ist. Mittels dieser Schwallrohre 160a und 160b wird wiederum das deionisierte Wasser 60 als Schutzflüssigkeit auf die Substrate 10 aufgebracht. Die Schwallrohre 160a, 160b dienen somit als Auftragvorrichtungen. Da sie in der Transportrichtung 16 der Substrate versetzt zueinander angeordnet sind, wird mittels dieser Schwallrohre 160a, 160b das deionisierte Wasser 60 mehrmals als Schutzflüssigkeit auf die Oberseite 15 der Substrate 10 aufgebracht.

Das mittels des Schwallrohres 160a auf die Oberseite 15 der Substrate 10 aufgebrachte deionisierte Wasser 60 bildet einen Schutzflüssigkeitsfilm 66a aus, welcher die Oberseite 15 im jeweiligen Anwendungsfall möglicherweise noch nicht vollständig bedeckt oder noch keine hinreichende Dicke aufweist. Insbesondere kann der Schutzflüssigkeitsfilm 66a Inseln gebildet haben, sodass Teile der Oberseite 15 nicht oder nicht hinreichend mit Schutzflüssigkeit bedeckt sind. Durch den zweiten Auftrag von deionisiertem Wasser 60 als Schutzflüssigkeit mittels des Schwallrohres 160b können Fehlstellen im Schutzflüssigkeitsfilm 66a ausgeglichen werden, sodass ein die Oberseite 15 der Substrate 10 vollständig bedeckender Schutzflüssigkeitsfilm 66b vorliegt. Weist der Schutzflüssigkeitsfilm 66a lediglich keine hinreichende Dicke auf, so bewirkt der Auftrag des deionisierten Wassers 60 mittels des Schwallrohres 160b einen dickeren Schutzflüssigkeitsfilm 66b.

Wie oben beschrieben, kann durch das mehrfache Aufbringen der Schutzflüssigkeit, im vorliegenden Fall des deionisierten Wassers 60, eine bessere Verteilung der Schutzflüssigkeit in Ecken der Substrate 10 und den Rändern der Substrate 10 bewirkt werden. Nach Durchlaufen des Spülbeckens 158 liegt bei dem Ausführungsbeispiel der Figur 6 somit ein Schutzflüssigkeitsfilm 66c vor, welcher die Oberseite 15 der Substrate 10 vollständig und homogen bedeckt. Je nach Anwendungsfall kann durch das mehrmalige Aufbringen von deionisiertem Wasser 60, beziehungsweise Schutzflüssigkeit, die Gesamtmenge überlaufenden Wassers 162 reduziert werden. Dies ermöglicht, insbesondere bei Verwendung anderer Schutzflüssigkeiten als Wasser, eine Reduktion des Aufwandes der Verfahrensführung.

Im Ausführungsbeispiel der Figur 6 ist ein weiteres Schwallrohr 160c zum Aufbringen des deionisierten Wassers 60 auf die Oberseite 15 der Substrate 10 über dem Behandlungsbecken 68, und somit in der Transportrichtung 16 der Substrate 10 nach dem Spülbecken 158, angeordnet. Das Schwallrohr 160c ist ebenso wie die Schwallrohre 160a und 160b dazu vorgesehen, deionisiertes Wasser 60 als Schutzflüssigkeit auf die Oberseite 15 der Substrate 10 aufzubringen. Auf diese Weise können Verluste an deionisiertem Wasser 60, welche der Schutzflüssigkeitsfilm 66c auf dem Weg zum Behandlungsbecken 68 erlitten hat, beispielsweise aufgrund von Verdampfung, ausgeglichen werden, sodass die Oberseite 15 der Substrate 10 über dem Behandlungsbecken 68 mittels eines idealen Schutzflüssigkeitsfilms 66d gegen ein Einwirken des Behandlungsmediums 70 und/oder dessen Ausgasungen geschützt ist.

In dem Ausführungsbeispiel der Figur 6 sind mit den Schwallrohren 160a, 160b, 160c drei Auftragvorrichtungen für Schutzflüssigkeit vorgesehen. Je nach den Bedürfnissen des einzelnen Anwendungsfalls kann eine dieser Auftragvorrichtungen, vorzugsweise das Schwallrohr 160b oder das Schwallrohr 160c, entfallen. Mit den verbleibenden zwei Schwallrohren liegen weiterhin mehrere in der Transportrichtung 16 der Substrate 10 versetzt zueinander angeordnete Auftragvorrichtungen vor, welche ein mehrmaliges Aufbringen von Schutzflüssigkeit, vorliegend deionisiertem Wasser 60, zum Zwecke des Ausbildens des Schutzflüssigkeitsfilms ermöglichen. In einem Anwendungsfall, in welchem die Schutzflüssigkeit derart dosiert aufgebracht werden kann, dass bei einem Aufbringen von Schutzflüssigkeit auf die Oberseite 15 des Substrats über dem Behandlungsbecken 68 praktisch keine Schutzflüssigkeit überläuft und somit auch nicht in die Ätzlösung 70 gelangt, hat es sich als besonders vorteilhaft erwiesen, an dem Schwallrohr 160c, oder allgemeiner an einer Auftragvorrichtung über dem Behandlungsbecken 68, festzuhalten.

Das in dem Ausführungsbeispiel der Figur 6 illustrierte Konzept mehrerer, in der Transportrichtung 16 der Substrate 10 versetzt zueinander angeordneter Auftragvorrichtungen kann ohne weiteres auf das Ausführungsbeispiel aus Figur 1 übertragen werden. Zu diesem Zweck wären bei dem Ausführungsbeispiel in Figur 1 in Transportrichtung 16 der Substrate nach dem Spülbecken eine oder mehrere Auftragvorrichtungen vorzusehen, mittels welcher wiederum deionisiertes Wasser als Schutzflüssigkeit auf die Oberseite 15 der Substrate aufgebracht werden kann. Beispielsweise könnten die aus Figur 6 bekannten Schwallrohre 160b oder 160c oder dergleichen Verwendung finden. Insbesondere könnte eine solche weitere Auftragvorrichtung über dem Behandlungsbecken 68 aus Figur 1 angeordnet werden.

Die Erfindung wurde anhand der dargestellten und erörterten Ausführungsbeispiele detaillierter beschrieben und illustriert.

### Bezugszeichenliste

- 10: Siliziumsubstrat
- 12: Phosphorsilikatglasschicht
- 13: Kante
- 14: Unterseite
- 15: Oberseite
- 16: Transportrichtung

- 50: Vorkonditionierungsbecken
- 52: hydrophobierende Flüssigkeit
- 54: Strukturrolle
- 55: Spitze
- 56: O-Ring-Rolle
- 58: Spülbecken

- 60: deionisiertes Wasser
- 62: überlaufendes Wasser
- 64: Überlaufbecken
- 66: Schutzflüssigkeitsfilm
- 66a: Schutzflüssigkeitsfilm
- 66b: Schutzflüssigkeitsfilm
- 66c: Schutzflüssigkeitsfilm
- 66d: Schutzflüssigkeitsfilm
- 68: Behandlungsbecken

- 70: Ätzlösung
- 72: Wellenelement
- 74: Ausnehmung
- 76: O-Ring
- 80: Ausnehmung
- 82: Wandung
- 158: Spülbecken
- 160: Schwallrohr
- 160a: Schwallrohr
- 160b: Schwallrohr
- 160c: Schwallrohr
- 162: überlaufendes Wasser

## Patentansprüche

1. Verfahren zum unterseitigen Behandeln eines flächigen Substrats (10) mit einem Behandlungsmedium (70), bei welchem
- eine Unterseite (14) des Substrats mittels einseitigen, nasschemischen Ätzens hydrophobiert wird;
- nachfolgend auf einer Oberseite (15) des Substrats (10) ein Schutzflüssigkeitsfilm (66) ausgebildet wird;
- nachfolgend das Behandlungsmedium (70) mit der Unterseite (14) des Substrats (10) in Kontakt gebracht und dabei die Oberseite (15) mittels des Schutzflüssigkeitsfilms (66) gegen ein Einwirken des Behandlungsmediums (70) und/oder dessen Ausgasungen geschützt wird.

2. Verfahren nach Anspruch 1,
**dadurch gekennzeichnet,**
**dass** ein Siliziumsubstrat (10) behandelt wird und zum Zwecke des Hydrophobierens der Unterseite (14) des Siliziumsubstrats (10) eine Silikatglasschicht (12) von der Unterseite (14) des Siliziumsubstrats (10) entfernt wird.

3. Verfahren nach einem der vorangegangenen Ansprüche,
**dadurch gekennzeichnet,**
**dass** zum Zwecke des Ausbildens des Schutzflüssigkeitsfilms (66) das Substrat (10) in eine Schutzflüssigkeit (60) eingetaucht und aus dieser entnommen wird, wobei bei der Entnahme des Substrats (10) aus der Schutzflüssigkeit (60) das Substrat (10) derart ausgerichtet wird, dass es sich in einer im Wesentlichen horizontal verlaufenden Ebene erstreckt, sodass auf der Oberseite (15) des Substrats (10) der Schutzflüssigkeitsfilm (66) verbleibt.

4. Verfahren nach einem der vorangegangenen Ansprüche,
**dadurch gekennzeichnet,**
**dass** vor dem Ausbilden des Schutzflüssigkeitsfilms (66) die Kanten (13) des Substrats hydrophobiert werden, vorzugsweise in einem gemeinsamen Verfahrensschritt mit dem Hydrophobieren der Unterseite (14) des Substrats (10).

5. Verfahren nach einem der vorangegangenen Ansprüche,
**dadurch gekennzeichnet,**
**dass** die Unterseite (14) des Substrats (10) mittels einseitigen, nasschemischen Ätzens hydrophobiert wird und zu diesem Zweck vorzugsweise das Substrat (10) von unten mit einer Ätzflüssigkeit (52) benetzt wird.

6. Verfahren nach Anspruch 5,
**dadurch gekennzeichnet, dass**
- nach dem zum Zwecke des Hydrophobierens vorgenommenen nasschemischen Ätzen zum Zwecke des Spülens eine Spülflüssigkeit (60) auf das Substrat (10) aufgebracht wird,
- die Menge der auf das Substrat (10) aufgebrachten Spülflüssigkeit (60) derart gewählt wird, dass mindestens die Hälfte der aufgebrachten Menge an Spülflüssigkeit (162) von dem Substrat (10) abtropft, und
- auf der Oberseite (15) des Substrats (10) verbleibende Spülflüssigkeit als Schutzflüssigkeitsfilm (66) verwendet wird.

7. Verfahren nach Anspruch 3 und Anspruch 5,
**dadurch gekennzeichnet,**
**dass** nach dem zum Zwecke des Hydrophobierens vorgenommenen nasschemischen Ätzen das Substrat (10) zum Zwecke des Spülens in eine Spülflüssigkeit (60) eingetaucht und diese Spülflüssigkeit (60) gleichzeitig als Schutzflüssigkeit (60) verwendet wird, sodass eine Entnahme des Substrats (10) aus der Spülflüssigkeit (60) gleichzeitig die Entnahme des Substrats (10) aus der Schutzflüssigkeit (60) darstellt.

8. Verfahren nach einem der vorangegangenen Ansprüche,
**dadurch gekennzeichnet,**
**dass** ein Ätzmedium (70) als Behandlungsmedium (70) verwendet wird und die Unterseite (14) des Substrats (10) mittels dieses Ätzmediums (70) geätzt wird.

9. Verfahren nach einem der vorangegangenen Ansprüche,
**dadurch gekennzeichnet,**
**dass** zum Zwecke des Ausbildens des Schutzflüssigkeitsfilms (66a, 66b, 66c, 66d) die Schutzflüssigkeit (60) mehrmals auf die Oberseite (15) des Substrats (10) aufgebracht wird.

10. Vorrichtung zur Durchführung des Verfahrens nach einem der Ansprüche 1 bis 9 aufweisend
- ein Vorkonditionierungsbecken (50), welches eine zu behandelnde Substrate (10) hydrophobierende Flüssigkeit (52) enthält;
- ein in einer Transportrichtung (16) der Substrate (10) dem Vorkonditionierungsbecken (50) nachgeordnetes Spülbecken (58);
- ein in der Transportrichtung (16) der Substrate (10) dem Spülbecken (58; 158) nachgeordnetes Behandlungsbecken (68), welches eine Behandlungsflüssigkeit (70) enthält;
- in dem Vorkonditionierungsbecken (50) angeordnete Transportrollen (54) zum Transport der Substrate (10) durch das Vorkonditionierungsbecken (50);
wobei in dem Vorkonditionierungsbecken (50) mehrheitlich, vorzugsweise ausschließlich, plateaulose Strukturrollen (54) als Transportrollen (54) vorgesehen sind.

11. Vorrichtung nach Anspruch 10,
**dadurch gekennzeichnet,**
**dass** in dem Spülbecken (58; 158) zum Transport der Substrate (10) durch das Spülbecken (58) mehrheitlich, vorzugsweise ausschließlich, O-Ring-Rollen (56) als Transportrollen vorgesehen sind, welche jeweils ein Wellenelement (72) sowie mehrere in Längsrichtung des Wellenelements (72) voneinander beabstandete O-Ring-Aufnahmen (74) aufweisen, wobei in den genannten O-Ring-Aufnahmen (74) jeweils ein O-Ring (76) angeordnet ist, welcher das Wellenelement (72) sowie die jeweilige O-Ring-Aufnahme (74) umfänglich umschließt.

12. Vorrichtung nach einem der Ansprüche 10 bis 11,
**dadurch gekennzeichnet,**
**dass** in dem Behandlungsbecken (68) zum Transport der Substrate (10) durch das Behandlungsbecken (68) mehrheitlich, vorzugsweise ausschließlich, plateaulose Strukturrollen (54) als Transportrollen vorgesehen sind.

13. Vorrichtung nach einem der Ansprüche 10 bis 12,
**dadurch gekennzeichnet,**
**dass** als hydrophobierende Ätzflüssigkeit (52) eine Flusssäure enthaltende Ätzlösung (52) vorgesehen ist und dass als Behandlungsflüssigkeit (70) eine weitere Ätzlösung (70) vorgesehen ist, welche Flusssäure und ein Oxidationsmittel, vorzugsweise Salpetersäure oder Wasserstoffperoxid, enthält.

14. Vorrichtung nach einem der Ansprüche 10 bis 13,
**dadurch gekennzeichnet, dass**
- mehrere Auftragvorrichtungen (160a, 160b, 160c) vorgesehen sind, mittels welchen eine Schutzflüssigkeit (60) auf eine Oberseite (15) der Substrate (10) aufbringbar ist;
- die mehreren Auftragvorrichtungen (160a, 160b, 160c) in der Transportrichtung (16) der Substrate (10) versetzt zueinander angeordnet sind;
- wenigstens eine der mehreren Auftragvorrichtungen (160a, 160b) über dem Spülbecken (158) angeordnet ist.

15. Vorrichtung nach Anspruch 14,
**dadurch gekennzeichnet,**
**dass** wenigstens eine der mehreren Auftragvorrichtungen (160c) in der Transportrichtung (16) der Substrate (10) nach dem Spülbecken (158) angeordnet ist.

## Claims

1. Method for treating the underside of a planar substrate (10) with a treatment medium (70), in which
- an underside (14) of the substrate is hydrophobized by means of one-sided, wet-chemical etching;
- subsequently, a protective liquid film (66) is formed on a top side (15) of the substrate (10) ;
- subsequently, the treatment medium (70) is brought into contact with the underside (14) of the substrate (10) and in the process the top side (15) is protected from any action of the treatment medium (70) and/or the outgassings thereof by means of the protective liquid film (66) .

2. Method according to claim 1,
**characterized**
**in that** a silicon substrate (10) is treated and, for the purpose of hydrophobizing the underside (14) of the silicon substrate (10), a silicate glass layer (12) is removed from the underside (14) of the silicon substrate (10).

3. Method according to any of the preceding claims,
**characterized**
**in that**, for the purpose of forming the protective liquid film (66), the substrate (10) is dipped into a protective liquid (60) and removed from the latter, wherein, when the substrate (10) is removed from the protective liquid (60), the substrate (10) is oriented such that it extends in a substantially horizontally extending plane, such that the protective liquid film (66) remains on the top side (15) of the substrate (10).

4. Method according to any of the preceding claims,
**characterized**
**in that**, before the protective liquid film (66) is formed, the edges (13) of the substrate are hydrophobized, preferably in a common method step with the hydrophobization of the underside (14) of the substrate (10).

5. Method according to any of the preceding claims,
**characterized**
**in that** the underside (14) of the substrate (10) is hydrophobized by means of one-sided, wet-chemical etching and for this purpose, the substrate (10) is preferably wetted from beneath with an etching liquid (52).

6. Method according to claim 5,
**characterized in that**
- after the wet-chemical etching carried out for the purpose of hydrophobization, a rinsing liquid (60) is applied to the substrate (10) for the purpose of rinsing,
- the quantity of rinsing liquid (60) applied to the substrate (10) is chosen such that at least half of the applied quantity of rinsing liquid (162) drips off the substrate (10), and
- rinsing liquid remaining on the top side (15) of the substrate (10) is used as the protective liquid film (66).

7. Method according to claim 3 and claim 5,
**characterized**
**in that** after the wet-chemical etching carried out for the purpose of hydrophobization, the substrate (10) is dipped into a rinsing liquid (60) for the purpose of rinsing and this rinsing liquid (60) is simultaneously used as the protective liquid (60), such that removal of the substrate (10) from the rinsing liquid (60) simultaneously represents the removal of the substrate (10) from the protective liquid (60).

8. Method according to any of the preceding claims,
**characterized**
**in that** an etching medium (70) is used as the treatment medium (70) and the underside (14) of the substrate (10) is etched by means of this etching medium (70).

9. Method according to any of the preceding claims,
**characterized**
**in that**, for the purpose of forming the protective liquid film (66a, 66b, 66c, 66d), the protective liquid (60) is applied to the top side (15) of the substrate (10) several times.

10. Device for carrying out the method according to any of claims 1 to 9, having
- a preconditioning tank (50) which contains a liquid (52) that hydrophobizes substrates (10) to be treated;
- a rinsing tank (58) that is arranged downstream of the preconditioning tank (50) in a transporting direction (16) of the substrates (10);
- a treatment tank (68) that is arranged downstream of the rinsing tank (58; 158) in the transporting direction (16) of the substrates (10), said treatment tank (68) containing a treatment liquid (70);
- transporting rollers (54), arranged in the preconditioning tank (50), for transporting the substrates (10) through the preconditioning tank (50);
wherein
predominantly, preferably exclusively, plateau-free structure rollers (54) are provided as transporting rollers (54) in the preconditioning tank (50) .

11. Device according to claim 10,
**characterized**
**in that** predominantly, preferably exclusively, O-ring rollers (56) are provided as transporting rollers in the rinsing tank (58; 158) in order to transport the substrates (10) through the rinsing tank (58), said O-ring rollers (56) each having a shaft element (72) and a plurality of O-ring receptacles (74) spaced apart from one another in the longitudinal direction of the shaft element (72), wherein an O-ring (76) is arranged in each of said O-ring receptacles (74), said O-ring circumferentially surrounding the shaft element (72) and the respective O-ring receptacle (74).

12. Device according to any of claims 10 to 11,
**characterized**
**in that** predominantly, preferably exclusively, plateau-free structure rollers (54) are provided as transporting rollers in the treatment tank (68) in order to transport the substrates (10) through the treatment tank (68).

13. Device according to any of claims 10 to 12,
**characterized**
**in that** an etching solution (52) containing hydrofluoric acid is provided as the etching liquid (52) for hydrophobization, and in that a further etching solution (70), which contains hydrofluoric acid and an oxidizing agent, preferably nitric acid or hydrogen peroxide, is provided as the treatment liquid (70).

14. Device according to any of claims 10 to 13,
**characterized in that**
- a plurality of application devices (160a, 160b, 160c) are provided, by means of which a protective liquid (60) is able to be applied to a top side (15) of the substrates (10);
- the plurality of application devices (160a, 160b, 160c) are arranged in an offset manner with respect to one another in the transporting direction (16) of the substrates (10);
- at least one of the plurality of application devices (160a, 160b) is arranged above the rinsing tank (158).

15. Device according to claim 14,
**characterized**
**in that** at least one of the plurality of application devices (160c) is arranged downstream of the rinsing tank (158) in the transporting direction (16) of the substrates (10).

## Revendications

1. Procédé de traitement du côté inférieur d'un substrat plat (10) avec un milieu de traitement (70),
selon lequel
- un côté inférieur (14) du substrat est hydrophobé au moyen d'une attaque chimique par voie humide d'un seul côté ;
- un film de liquide de protection (66) est ensuite réalisé sur un côté supérieur (15) du substrat (10) ;
- le milieu de traitement (70) est ensuite mis en contact avec le côté inférieur (14) du substrat (10) et le côté supérieur (15) est alors protégé au moyen du film de liquide de protection (66) contre une action du milieu de traitement (70) et/ou de ses dégagements gazeux.

2. Procédé selon la revendication 1, **caractérisé en ce qu'**un substrat de silicium (10) est traité et, en vue de l'hydrophobation du côté inférieur (14) du substrat de silicium (10), une couche de verre de silicate (12) est enlevée du côté inférieur (14) du substrat de silicium (10) .

3. Procédé selon l'une quelconque des revendications précédentes, **caractérisé en ce qu'**en vue de la réalisation du film de liquide de protection (66), le substrat (10) est immergé dans un liquide de protection (60) et retiré de celui-ci ; lors du retrait du substrat (10) du liquide de protection (60), le substrat (10) étant orienté de telle sorte qu'il s'étend dans un plan essentiellement horizontal, de telle sorte que le film de liquide de protection (66) reste sur le côté supérieur (15) du substrat (10).

4. Procédé selon l'une quelconque des revendications précédentes, **caractérisé en ce qu'**avant la réalisation du film de liquide de protection (66), les bords (13) du substrat sont hydrophobés, de préférence dans une étape de procédé commune avec l'hydrophobation du côté inférieur (14) du substrat (10).

5. Procédé selon l'une quelconque des revendications précédentes, dans lequel le côté inférieur (14) du substrat (10) est hydrophobé au moyen d'une attaque chimique par voie humide d'un seul côté et, à cette fin, le substrat (10) est de préférence mouillé par le dessous avec un liquide d'attaque (52).

6. Procédé selon la revendication 5, **caractérisé en ce que**
- après l'attaque chimique par voie humide effectuée en vue de l'hydrophobation, un liquide de rinçage (60) est appliqué sur le substrat (10) en vue du rinçage,
- la quantité de liquide de rinçage (60) appliquée sur le substrat (10) est choisie de telle sorte qu'au moins la moitié de la quantité de liquide de rinçage (162) appliquée s'égoutte du substrat (10), et
- le liquide de rinçage restant sur le côté supérieur (15) du substrat (10) est utilisé en tant que film de liquide de protection (66).

7. Procédé selon la revendication 3 et la revendication 5, **caractérisé en ce qu'**après l'attaque chimique par voie humide effectuée en vue de l'hydrophobation, le substrat (10) est immergé dans un liquide de rinçage (60) en vue du rinçage et ce liquide de rinçage (60) est utilisé simultanément en tant que liquide de protection (60), de telle sorte qu'un retrait du substrat (10) du liquide de rinçage (60) constitue simultanément le retrait du substrat (10) du liquide de protection (60).

8. Procédé selon l'une quelconque des revendications précédentes, **caractérisé en ce qu'**un milieu d'attaque (70) est utilisé en tant que milieu de traitement (70) et le côté inférieur (14) du substrat (10) est attaqué au moyen de ce milieu d'attaque (70).

9. Procédé selon l'une quelconque des revendications précédentes, **caractérisé en ce qu'**en vue de la réalisation du film de liquide de protection (66a, 66b, 66c, 66d), le liquide de protection (60) est appliqué plusieurs fois sur le côté supérieur (15) du substrat (10) .

10. Dispositif pour la mise en œuvre du procédé selon l'une quelconque des revendications 1 à 9, présentant
- un bassin de préconditionnement (50), lequel contient un liquide (52) hydrophobant les substrats (10) à traiter ;
- un bassin de rinçage (58) agencé en aval du bassin de préconditionnement (50) dans une direction de transport (16) des substrats (10) ;
- un bassin de traitement (68) agencé en aval du bassin de rinçage (58 ; 158) dans la direction de transport (16) des substrats (10), lequel contient un liquide de traitement (70) ;
- des rouleaux de transport (54) agencés dans le bassin de préconditionnement (50) pour le transport des substrats (10) à travers le bassin de préconditionnement (50) ;
des rouleaux de structure sans plateau (54) étant majoritairement, de préférence exclusivement, prévus dans le bassin de préconditionnement (50) en tant que rouleaux de transport (54).

11. Dispositif selon la revendication 10, **caractérisé en ce qu'**il est prévu dans le bassin de rinçage (58 ; 158) pour le transport des substrats (10) à travers le bassin de rinçage (58), en majorité, de préférence exclusivement, des rouleaux à joint torique (56) en tant que rouleaux de transport, qui présentent chacun un élément d'arbre (72) ainsi que plusieurs logements de joint torique (74) espacés les uns des autres dans la direction longitudinale de l'élément d'arbre (72), un joint torique (76) étant agencé dans chacun desdits logements de joint torique (74), lequel entoure circonférentiellement l'élément d'arbre (72) ainsi que le logement de joint torique (74) respectif.

12. Dispositif selon l'une quelconque des revendications 10 à 11, **caractérisé en ce qu'**il est prévu dans le bassin de traitement (68), pour le transport des substrats (10) à travers le bassin de traitement (68), majoritairement, de préférence exclusivement, des rouleaux de structure sans plateau (54) en tant que rouleaux de transport.

13. Dispositif selon l'une quelconque des revendications 10 à 12, **caractérisé en ce qu'**il est prévu en tant que liquide d'attaque hydrophobant (52) une solution d'attaque (52) contenant de l'acide fluorhydrique et **en ce qu'**il est prévu en tant que liquide de traitement (70) une autre solution d'attaque (70) qui contient de l'acide fluorhydrique et un agent oxydant, de préférence de l'acide nitrique ou du peroxyde d'hydrogène.

14. Dispositif selon l'une quelconque des revendications 10 à 13, **caractérisé en ce que**
- plusieurs dispositifs d'application (160a, 160b, 160c) sont prévus, au moyen desquels un liquide de protection (60) peut être appliqué sur un côté supérieur (15) des substrats (10) ;
- les plusieurs dispositifs d'application (160a, 160b, 160c) sont agencés en étant décalés les uns par rapport aux autres dans la direction de transport (16) des substrats (10) ;
- au moins un des plusieurs dispositifs d'application (160a, 160b) est agencé au-dessus du bassin de rinçage (158) .

15. Dispositif selon la revendication 14, **caractérisé en ce qu'**au moins un des plusieurs dispositifs d'application (160c) est agencé en aval du bassin de rinçage (158) dans la direction de transport (16) des substrats (10).
